# EUROPEAN PATENT SPECIFICATION

(11) **EP 4 131 676 B1**
(45) Date of publication and mention of the grant of the patent: **12.06.2024**
(21) Application number: 21189897.8
(22) Date of filing: 05.08.2021
(51) Int. Cl.: H01S 5/183

(54) **VERTICAL CAVITY SURFACE EMITTING LASER AND METHOD OF FABRICATING SAME**
OBERFLÄCHENEMITTIERENDER DIODENLASER UND VERFAHREN ZUR HERSTELLUNG DAVON
LASER À CAVITÉ VERTICALE ET À ÉMISSION PAR LA SURFACE ET SON PROCÉDÉ DE FABRICATION

(43) Date of publication of application: 08.02.2023
(73) Proprietor: TRUMPF Photonic Components GmbH, 89081 Ulm (DE)
(72) Inventor: WEIGL, Alexander, 89312 Günzburg (DE); GRONENBORN, Stephan, 52066 Aachen (DE)
(74) Representative: Trumpf Patentabteilung

(56) References cited:
- US-A1- 2002 141 472
- GADALLAH ABDEL-SATTAR ET AL: "High-power single-higher-order-mode VCSELs for optical particle manipulation", PROCEEDINGS OF SPIE, vol. 7720, 26 April 2010 (2010-04-26), page 77201Y, XP55877496, 1000 20th St. Bellingham WA 98225-6705 USA ISSN: 0277-786X, DOI: 10.1117/12.854319 ISBN: 978-1-5106-4548-6
- GADALLAH ABDEL-SATTAR ET AL: "Oblong-shaped VCSELs with pre-defined mode patterns", PROCEEDINGS OF SPIE, vol. 6997, 25 April 2008 (2008-04-25), page 69971R, XP55877503, 1000 20th St. Bellingham WA 98225-6705 USA ISSN: 0277-786X, DOI: 10.1117/12.781099 ISBN: 978-1-5106-4548-6

## Description

### FIELD THE INVENTION

The present invention relates to the field of Vertical Cavity Surface Emitting Lasers (VCSEL). The invention further relates to methods of fabricating VCSELs.

### BACKGROUND OF THE INVENTION

VCSELs are used in numerous applications due to their characteristics such as single mode behavior, low thresholds, high speed modulation and low costs. VCSELs can be densely packed to form two-dimensional arrays. Thus, VCSEL arrays are often employed as the means to achieve high output power. While none-coherent arrays may be sufficient in some applications which merely need high power, other applications need low beam divergence and high spectral purity. Coherently coupled VCSEL arrays can select a single lasing mode to achieve focused, diffraction-limited beam characteristics.

Coherent coupling has been investigated in the art. For best on-chip integration of VCSELs, next-neighbor coupling is preferred over e.g. Master-Slave configurations or Talbot-cavities as those require precisely aligned external optics.

However, next-neighbor coupling requires a small center-to-center distance between the lasers in the order of the mode diameter of a few µm, which is not achievable with standard VCSEL processing. For example, a separate mesa etch, the oxidation width plus the area for metal contacts lead to dimensions which already are much larger than the mode size. Further, for coherent coupling, the VCSELs must run on very similar current and internal temperature, such that their resonance wavelength under operation conditions is basically the same. If the resonance is very different, the lasers cannot coherently couple with each other.

US 2019/0341741 A1 discloses a pixel structure for a VCSEL which has an emission window. The pixel structure includes a plurality of sub-pixels in the emission window. Bright-area sub-pixels emit light and dark-area sub-pixels have no light emission. The bright-area sub-pixels and the dark-area sub-pixels are arranged in a pattern in the emission window. Such VCSELs are used for generating two-dimensional code patterns. Gadallah Abdel-Sattar et al. disclose in the article "High-power single-higher-order-mode VCSELs for optical particle manipulation", proceedings of SPIE, vol. 7720, 26 April 2010, page 77201Y oxide-confined large-area rectangular-shaped VCSELs according to the preamble of claim 1 that emit a single higher-order transverse mode. The mode selection mechanism is based on an inverted surface relief. Extra losses are induced by a quarterwavelength-thick antiphase layer, into which a multi-spot pattern is etched in a single step. Gadallah Abdel-Sattar et al. disclose in the article "Oblong-Shaped VCSELs with PreDefined Mode Patterns", proceedings of SPIE, vol. 6997, 25 April 2008 page 69971R VCSEL designs similar to the VCSEL designs in the article mentioned before.
US 2002/141472 A1 discloses VCSELs which satisfy a requirement of making a transverse mode stable and having characteristics of high output power, low resistance, high efficiency, and high speed response. Holes or trenches are formed on the top surface of an upper multilayer reflection film formed in the shape of a post by the use of a focused ion beam processing unit. One hole is formed on the surface of an upper multilayer reflection film corresponding to the center position of a square or circular current injection region which is about 8 µm square and the remaining holes are formed at the corners of the square current injection region or trenches are formed in and at the perimeter of the circular current region

### SUMMARY OF THE INVENTION

It is an object of the present invention to provide a VCSEL with high quality laser output emission.

It is a further object of the present invention, to provide a VCSEL which enables next-neighbor coherent coupling of laser emission.

It is another object to provide a VCSEL which may be fabricated with low costs.

It is a further object of the present invention to provide a method of fabricating a VCSEL.
A Vertical Cavity Surface Emitting Laser according to the claimed invention is defined in claim 1. A method of fabricating a Vertical Cavity Surface Emitting Laser according to the claimed invention is defined in claim 9.

A Vertical Cavity Surface Emitting Laser (VCSEL) is provided, comprising a semiconductor layer structure including a first mirror, an outcoupling mirror and an active region between the first mirror and the outcoupling mirror, further comprising an electrical contact arrangement, and a current confinement region which surrounds a contiguous area of the layer structure, wherein the electrical contact arrangement is arranged to pump the active region to generate laser emission in a single non-fundamental mode extending over the contiguous area, wherein the outcoupling mirror has a first reflectivity in one or more first sub-areas of the contiguous area and a second reflectivity in one or more second sub-areas of the contiguous area outside the one or more first sub-areas, wherein the second reflectivity is lower than the first reflectivity and the single non-fundamental mode has single intensity peaks in the one or more first sub-areas and an intensity in the one or more second sub-areas which is lower than 50% of the intensity in the first sub-areas.

Differently from conventional VCSEL arrays having two or more mesas electrically separated from each other and electrically pumped individually, the VCSEL according to the invention comprises a contiguous area defined by a current or optical confinement region surrounding the contiguous area. "Contiguous" area is to be understood as a large area which may be electrically pumped in a uniform manner for the case of current confinement. It can also be understood as a large area surrounded by a feature acting as a waveguide or other feature of optical confinement. It can also be a combination of both. An oxide aperture in a VCSEL is one example where the oxide aperture realizes both functions of electrical and optical confinement at the same time. Another example is the realization of an oxide aperture on a large area for optical confinement and an electrical confinement in a smaller area by e.g. additional ion-implantation or buried tunnel-junctions. Instead of a plurality of separate mesa etches, only one mesa etch is needed to fabricate the VCSEL according to the invention, to form an electrically contiguous area of the layer structure of the VCSEL. Thus, the whole contiguous area may be run on a uniform current distribution and uniform internal temperature so that the resonance wavelength of the optical resonator formed by the first mirror, the outcoupling mirror and the active region is substantially the same over the contiguous area.

Laser emission of a single high-order mode occurs with high intensity in the one or more first sub-areas. Each first sub-area may also be referred to as one or more single lasers. These single lasers are not separated from each other by respective mesa etches. The electrical contact arrangement may comprise a metal contact extending outside and along the entire contiguous area. Thus, the center-to-center distance between the lasers (first sub-areas) can be made small enough for next-neighbor coupling of the laser emissions from the first sub-areas.

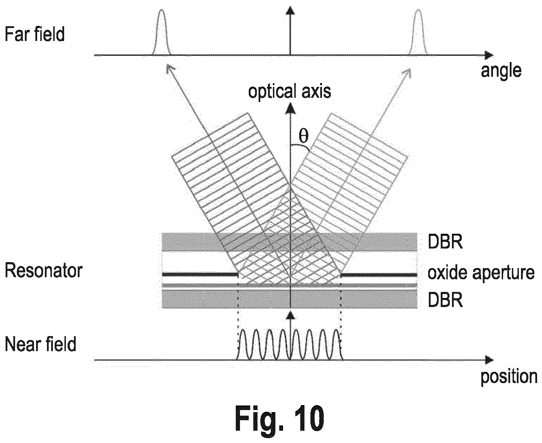

Alternatively, the single high-order mode can be understood as a high order mode of the optical confinement region acting like a waveguide. Optical modes of a laser resonator are usually described in terms of Gaussian modes. However, if the Fresnel number of a homogeneous resonator increases the optical modes are best described in terms of Fourier modes. The Fresnel number *NF* = *D²*/*λL* is defined as the square of the lateral extension *D* divided by the product of the wavelength *λ* and the effective cavity length *L* and is an indicator for diffraction inside the resonator. Most large Fresnel number resonators have been realized in Vertical-Cavity Surface-Emitting Laser diodes (VCSELs) because the effective cavity length is only some micrometers, while the diameter of the gain area can be increased well above 20 *µ*m. Fourier modes have been observed experimentally in square- and circular-shaped VCSELs. However, the simplest case - a single Fourier mode consisting of only two tilted-plane waves with the opposite transverse wave vector forming a linear interference pattern in the near field that fills the full resonator and two peaks in the far field - was shown in S. Gronenborn, T. Schwarz, P. Pekarski, M. Miller, H. Mönch and P. Loosen, "Optical Modes in a Rectangular VCSEL Resonator With Properties of Both Gaussian and Fourier Modes", in IEEE Journal of Quantum Electronics, vol. 48, no. 8, pp. 1040-1044, Aug. 2012. Fourier modes consist of plane waves which can be tilted with respect to the optical axis of the resonator by an angle *θ*, such that the wave vector component *k*∥ parallel to the optical axis fulfills the resonance condition *k*∥(*m*L) = |*k*| cos(*θ*) = *πm*L / Left with *m*L being the longitudinal mode order. If the lateral boundaries are at least partially reflecting, the mode consists of two coherent, counter propagating plane waves. Figure 10 illustrates the two plane waves inside the resonator superposing to an interference pattern with a spatial frequency of *v*/ = 2 sin(*θ*Cav)*n*/*λ*≈ 2 sin(*θ* )/*λ (equation 1)* where *θ*Cav is the angle inside the cavity, *θ*≈ arcsin(n sin(*θ*Cav)) is the angle in air, *n* is the average refractive index inside the cavity and A the wavelength in vacuum. Oxide-confined VCSELs are limited in size by reflecting boundaries and the plane waves leaving the resonator are truncated by the aperture. Consequently, far field peaks are formed as a diffraction pattern of the oxide aperture. Additionally, the wave vector has to fulfill a second resonance condition for *k*⊥, leading to the discretization of the mode spectrum: *k*⊥*(m*T*)* = |*k*|(*m*T) sin(*θ*Cav) = *πm*T/*D* where *m*T is the transversal mode order. This results in a discrete mode of the plane waves with angles *θ(mT)* given by *θ*Cav*(mT)* = arctan(k∥/*k*⊥*(m*T*))*. For the x-direction the VCSEL can be described as a homogeneously illuminated slit with the size of the aperture *D*. Thus, the emission of VCSELs with a large dimension > 20µm can be well described by the Fourier mode model, while the emission in the small direction <20µm is similar to the standard single-mode VCSELs. The far field emission patterns have also been modeled as numerical solution of the Fraunhofer diffraction integral of a calculated near field intensity profile, which was given by an interference pattern in the x-direction given by equation 1 above and with a Gaussian shape w0 in the y-direction.

Preferably, the first and second sub-areas may be arranged in a periodical arrangement, in particular such that the intensity peaks of the single non-fundamental mode emerging from the one or more first sub-areas form a periodical arrangement.

The contiguous area may have one, two or more than two first sub-areas (lasers), e.g. at least 5, or at least 10, or at least 20. Neighboring first sub-areas may partially overlap each other so as to form one first sub-area. The first sub-areas may also be separated from each other so that there is a second sub-area between two neighboring first sub-areas. The current confinement region may be realized by an oxidation of the layer structure, which at the same time acts as an optical confinement region. The current confinement region may also be realized by ion implantation. In case of a current confinement region in form of an oxide aperture, the oxide aperture also provides optical confinement for the single non-fundamental mode, i.e. functions as a waveguide. Alternatively or in addition, ion implantation for providing current confinement is also possible, without providing optical confinement. The combination of oxide aperture and ion implantation allows a separation of the optical confinement region by the oxide aperture and an electrical confinement region of a smaller size or different shape by the ion implantation.

In the second sub-area(s) outside the first sub-area(s), the reflectivity of the outcoupling mirror is lower than the reflectivity of the outcoupling mirror in the first sub-area(s). The laser emission intensity in the respective second sub-areas is lower than in the first sub-areas. The VCSEL according to the invention may provide a coherently coupled array of lasers in the contiguous area of the layer structure. The single non-fundamental mode, which may be a single higher-order mode, extends over the first sub-areas and the second sub-areas, but with varying intensity along the first and second sub-areas. Intensity peaks of the single high-order mode are present in the first sub-areas, and intensity minima in the second sub-area(s). In the first sub-areas, the intensity of the emission of the single non-fundamental mode may be above 50% of the peak intensity of the mode, and in the second sub-area(s) below 50% of the peak intensity. If the electrical field of the single mode emitted from immediately neighboring first sub-areas is in-phase, light emission occurs everywhere in the first sub-areas and the second sub-areas, but with a lower non-zero intensity in the second sub-areas. If the electrical field of the single mode emitted from immediately neighboring first sub-areas is out-of-phase, there is an infinitesimally small area between the first sub-areas where the electrical field direction switches from - to + and the intensity is 0 in this infinitesimally small area only.

The outcoupling mirror may be configured as a distributed Bragg reflector (DBR). Different reflectivities of the outcoupling mirror in the first sub-areas and the second sub-areas may be realized in several ways which will be described herein.

By varying the reflectivity of the outcoupling mirror along the contiguous area, such that the reflectivity above the intended laser positons (intensity peaks of the first sub-area(s)) is higher than the reflectivity outside the intended laser positions (second sub-area(s)), laser threshold carrier density will be reduced at the intended laser positions compared to the other regions (second sub-areas) so that lasing will start with increasing current at these intended laser positions. If the center-to-center spacing of the lasing areas is small enough, there will not be enough carriers left in the other regions to allow lasing there even if the carrier is increased. At the same time, electrical fields of the lasing areas (intensity peaks of the first sub-area(s)) overlap to allow coherent coupling of the array of lasing areas.

In case of the optical confinement defining the laser modes as described above, the first sub-area(s) should be realized at the positions of the intensity peaks of the desired single-non-fundamental mode or in general in the one or more areas where the intensity of the desired mode is high. At the same time, the one or more second sub-areas having a lower reflectivity, are positioned in the area where the intensity of the desired mode is low, preferably < 50%, more preferably < 20%. Other modes which are not desired, will have a higher intensity or preferably at least one intensity peak in the area of the second sub-area(s). This will lead to larger outcoupling losses for these modes and thus a larger threshold current. By this measure, the desired single non-fundamental mode will be preferred and will be the only lasing mode, while the other modes (which would also start lasing in a VCSEL with the same contiguous area but without the second sub-areas) will be suppressed.

The VCSEL according to the invention does not only enable a high output power in a single coherent mode, but may also be fabricated with low costs.

Preferred embodiments of the invention are defined in the dependent claims.

The contiguous area has a ring shape. A ring shape of the contiguous area is very suitable to achieve a homogeneous current and carrier distribution in the contiguous area. In case of a ring-shaped contiguous area, a second current confinement region is provided on the radially inner side of the ring-shaped contiguous area.

In an embodiment, the center-to-center pitch (distance) of neighboring first sub-areas is in a range from 0.75 to 1.75 times a single first sub-area diameter. Thus, a dense and closely packed arrangement of first sub-areas may be achieved to improve coherent coupling of the laser emissions from the first sub-areas. For values of the center-to-center pitch below 1, the first sub-areas have some small overlap and the first sub-areas may be considered as one first sub-area with a plurality of intensity peaks of the single non-fundamental mode emerging therefrom. Preferably, the center-to-center pitch may be in a range from 1.00 to 1.50.

In a further embodiment, the reflectivity of the outcoupling mirror may be varied over the contiguous area such that the intensity of the single non-fundamental mode in the first sub-areas is larger than the intensity of the single non-fundamental mode in the second sub-areas by a factor of at least 3, preferably at least 4, further preferably at least 5, and may be at least 10.

The first sub-areas and the second sub-areas may be arranged such that the intensity peaks of the single non-fundamental mode in the one or more first subareasare out-of-phase among two immediately neighboring intensity peaks.

As the optical loss is increased in the second sub-areas, the out-of-phase mode is preferred compared to the in-phase mode as the latter has some non-zero electrical field in the center between two intensity peaks, while the out-of-phase has zero electrical field there and thus lower losses and hence a lower threshold.

Alternatively, the first sub-areas and the second sub-areas may be arranged such that the intensity peaks of the single non-fundamental mode in the one or more first sub-areas is in-phase among two immediately neighboring intensity peaks.

When the out-of-phase mode is chosen, the outcoupling mirror may comprise an additional layer which alters the phase of each second intensity peak from out-of-phase to in-phase or vice versa, i.e. alters the phase of each second intensity peak by 180°.

In a further embodiment, a grating structure may be arranged on the one or more first sub-areas which is configured to stabilize a single polarization direction of the laser emission.

In a further embodiment, in a region of the one or more second sub-areas, the layer stack may comprise an ion implant in order to decrease electrical losses in the regions between the one or more first sub-areas (lasing areas) or at the edges of the lasing areas where the intensity of the mode is low.

The contiguous area is electrically separated from remaining portions of the layer stack by a trench.

Providing the outcoupling mirror with different reflectivities in the first sub-area(s) and the second sub-area(s) may be accomplished according to one or more of the following embodiments.

The outcoupling mirror may be provided with a top layer forming a semiconductor-to-air interface, which is out-of-phase with the remaining layers of the outcoupling mirror. By etching part of the top layer, the semiconductor-to-air interface can be made in-phase to increase the reflectivity in the etched areas to form the one or more first sub-areas. An etch stop layer might be added to improve accuracy of the etched depth.

In another embodiment, the outcoupling mirror may be realized with a top layer forming a semiconductor-to-air interface, which is in-phase with the remaining layers of the outcoupling mirror. By etching parts of the top layer, the semiconductor-to-air interface can be made out-of-phase to decrease the reflectivity in the etched area(s) to form the second sub-area(s).

In another embodiment, the outcoupling mirror may be provided with a semiconductor-to-air interface being in-phase with the remaining layers of the outcoupling mirror. By spatial deposition of an additional layer (or full area deposition and partial removal of the layer by e.g. etching), for example an antireflex-layer, the reflectivity is reduced in the area(s) where the layer is present.

In another embodiment, the outcoupling mirror may be provided with a semiconductor-to-air interface being out-of-phase with the remaining layers of the outcoupling mirror. By spatial deposition of an additional layer (or full area deposition and partial removal of the layer by e.g. etching), for example an antireflex-layer, the reflectivity is increased in the area(s) where the layer is present.

In another embodiment, additional reflectivity may be provided by adding dielectric mirror(s) on some areas (or over the full area and etching them away in other areas) of the outcoupling mirror.

It shall be understood that the claimed method has similar and/or identical preferred embodiments as the claimed VCSEL, in particular as defined in the dependent claims and as disclosed herein.

Further advantageous embodiments are defined below.

### BRIEF DESCRIPTION OF THE DRAWINGS

These and other aspects of the invention will be apparent from and elucidated with reference to the embodiments described hereinafter. In the following drawings:
Fig. 1 shows a schematic top plan view of an example useful for the understanding of the invention of a Vertical Cavity Surface Emitting Laser (VCSEL) not covered by the claims
Fig. 2 is a section through the VCSEL in Fig. 1 along line II-II in Fig. 3;
Fig. 3 is a section through the VCSEL in Fig. 1 along line III-III in Fig. 1;
Fig. 4 is a section through a portion of an outcoupling mirror of the VCSEL according to an example useful for the understanding of the invention;
Fig. 5 is a section trough a portion of an outcoupling mirror according to another example useful for the understanding of the invention;
Fig. 6 is a schematic top plane view of an embodiment of a VCSEL according to the claimed invention;
Figs. 7a), b), c) show diagrams of a simulation of laser emission in the near-field (upper row of diagrams) and far-field (lower row of diagrams) for a straight arrangement of lasing areas of a VCSEL with in-phase coupling (Fig. 7a), without coupling (Fig. 7b), and with out-of-phase coupling (Fig. 7c);
Figs. 8a), b), c) show diagrams of a simulation of laser emission in the near-field (upper row of diagrams) and far-field (lower row of diagrams) for a ringarrangement of lasing areas of a VCSEL with in-phase coupling (Fig. 8a), without coupling (Fig. 8b), and with out-of-phase coupling (Fig. 8c);
Fig. 9 shows a schematic top plan view of a section of an example useful for the understanding of the invention modified with respect to the embodiment in Fig 1; and
Fig. 10 shows a sketch illustrating two plane waves inside a resonator superposing to an interference pattern.

### DETAILLED DESCRIPTION OF EMBODIMENTS

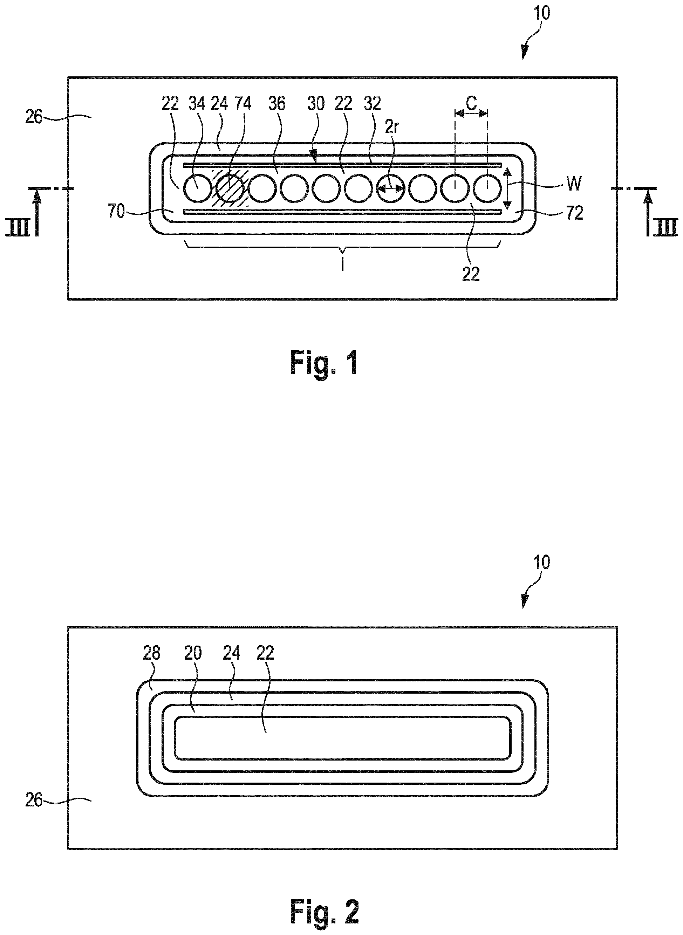

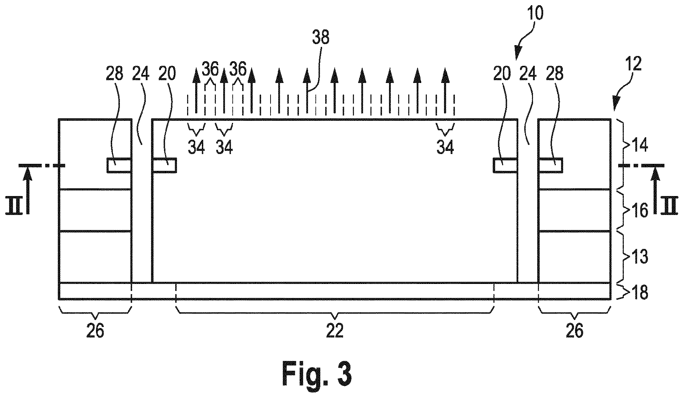

Figs. 1 to 3 schematically show a Vertical Cavity Surface Emitting Laser (VCSEL) according to an example useful for the understanding of the invention. The VCSEL 10 comprises a semiconductor layer structure which will be described with reference to Fig. 3. The semiconductor layers of the semiconductor layer structure 12 may be based on the AIGaAs/GaAs-system, for example. The semiconductor layer structure 12 includes a first mirror 13. The first mirror 13 may be configured as a distributed Bragg reflector (DBR). As known in the art, the DBR may comprise a layer structure of alternating high-refractive index layers and low-refractive index layers (not shown). The layers are not shown in detail here. The semiconductor layer structure 12 further includes an outcoupling mirror 14. The outcoupling mirror 14 may be configured as a DBR. The DBR may comprise alternating high-refractive index layers and low-refractive index layers (not shown).

The first mirror 13 may have a reflectivity of at least 99.9%. The outcoupling mirror 14 may have a reflectivity in a range from 99% to 99.8%, for example. While the outcoupling mirror 14 is shown here as the top mirror, the outcoupling mirror 14 may be the bottom mirror in alternative embodiments

Between the first mirror 13 and the outcoupling mirror 14, an active region 16 is arranged which, when electrically pumped, generates laser emission. The active region may comprise multiple quantum wells, as known in the art.

The semiconductor layers of the semiconductor layer structure 12 may be epitaxially grown on a substrate 18.

With reference to Figs. 2 and 3, a current confinement region 20 surrounds a contiguous area 22 of the layer structure 12. The current confinement region 20 may be made by an oxidation of one or more layers of the semiconductor layer structure 12, for example oxidation of one or more layers of the outcoupling mirror 14. For example, an AlGaAs or an AlAs layer with high Al-content comprised by the layer structure 12 can be oxidized to form insulating AlO₂. When the current confinement region 20 is formed by oxidation, a trench 24 is formed, e.g. etched, prior to the oxidation process. The trench 24 separates the contiguous area 22 from remaining areas 26, which comprise the same layers of the semiconductor layer structure 12 as the contiguous area 22. The area 22 may also be referred to as electrically contiguous area. The oxidation process used for forming the current confinement region 20 may also form an oxidized region 28 in the remaining region 26 of the semiconductor layer structure 12.

Alternatively to forming the current confinement region 20 by oxidation, the current confinement region 20 may also be formed by ion implantation, as known in the art.

The VCSEL 10 further comprises an electrical contact arrangement 30 which is arranged to pump the active region 16 to generate laser emission. The electrical contact arrangement 30 may comprise one or more metal contacts 32 arranged next to, but outside the contiguous area 22, e.g. above the current confinement region 20, on top of the layer structure 12. The metal contact 32 may be a p-contact. The electrical contact arrangement further comprises a second metal contact (not shown). The second metal contact may be arranged e.g. on the backside of the substrate 18, or may be formed as an intra-cavity contact on the layer structure 12-side of the substrate 18. The substrate 18 itself may be used as an electrical contact. The second contact may be an n-contact if the metal contact 32 forms the p-contact. In this regard, the first mirror 13 may be n-doped, and the outcoupling mirror 14 may be p-doped.

The electrical contact arrangement 30 electrically pumps the active region 16 in a uniform manner, i.e. the current distribution in the contiguous area is substantially homogeneous. Pumping the active region 16 generates a single non-fundamental mode of laser emission extending along the full contiguous area 22.

A method of fabricating the VCSEL 10 may comprise the following processing steps. The layer stack 12 of semiconductor layers is provided by epitaxially growing the semiconductor layers of the first mirror 13, the active region 16, and the outcoupling mirror 14 on the substrate 18.

The contiguous area 22 may be formed by etching the semiconductor layer stack 12 so as to form the trench 24. By subsequent oxidation, the current confinement region 20 is formed which surrounds the electrically contiguous area 22 on all sides. As mentioned above, ion implantation may be performed instead of oxidation to form the current confinement region 20.

The electrical contact arrangement is provided by arranging the metal contact(s) 32 on top of the outcoupling mirror 14 and a second contact on the backside of the substrate 18, for example.

With reference to Figs. 1 to 3 again, the VCSEL will be described further.

The outcoupling mirror 14 has, in the contiguous area 22, a first reflectivity R₁ in one or more first sub-areas 34, and a second reflectivity R₂ in one or more second sub-areas 36 outside the one or more first sub-area(s). The second reflectivity R₂ is lower than the first reflectivity R₁. In Fig. 1, the first sub-areas 34 are separated from each other and are illustrated by circles. Several ways to vary the reflectivity of the outcoupling mirror 14 over the contiguous area 22 will be described further below. The first reflectivity R₁ may be, for example, > 99%, e.g. 99.5%, and the reflectivity in the second sub-area 36 may be < 99%, e.g. 98.5%.

The first sub-areas 34 are areas where laser emission will occur. The first sub-areas thus form lasing areas or laser positions. The higher reflectivity of the outcoupling mirror 14 in the first sub-areas 34 reduces the laser threshold carrier density at the first sub-areas 34 compared to the second sub-areas 36 outside the first areas 34. The first areas 34 thus form areas where lasing will start with increasing current when the VCSEL 10 is electrically pumped. If the center-to-center spacing c (Fig. 1) of the first sub-areas (lasing areas) is small enough, there will not be enough carriers left in the second sub-areas 36 to allow lasing there, even if the current is increased. At the same time, the electrical field of the lasing areas 34 (first sub-areas) overlap to allow coherent coupling of the laser emission emitted from the first sub-areas 34.

When the active region 16 is electrically pumped, laser emission in a single non-fundamental mode extending over the electrically contiguous area 22 is generated. Laser emission of high intensity occurs in the first sub-areas 34 with the higher reflectivity R₁ of the outcoupling mirror 14, while there is some low-intensity laser emission in the second sub-areas 36. The intensity in the second sub-areas 36 is below 50% of the intensity in the first sub-areas, e.g. below 40%. e.g. below 30%, e.g. below 20%, e.g. below 10%, but there will be some non-zero intensity. Thus, a VCSEL array with a plurality of lasing areas is formed by the VCSEL 10 in a single large-area contiguous area 22. The contiguous area 22 should be large enough to enclose at least two first sub-areas 34, i.e. at least two lasing areas, with a mode diameter in the range of 2 µm to 10 µm.

The first sub-areas 34 preferably form a linear arrangement of first sub-areas 34 along the contiguous area 22.

The contiguous area may have an elongated shape with an aspect ratio between a long dimension and a short dimension of the electrically contiguous area 22 of larger than 3:1, preferably larger than 5:1, further preferably larger than 10:1. In the embodiment in the Figs. 1 to 3, the contiguous area 22 has a rectangular shape 22.

As an example, to create a VCSEL with 10 lasing areas 34, the contiguous area 22 may be a rectangle with a width w of 8 µm and a length I of 66 µm, if a center-to-center pitch c shall be 6 µm. The mode diameter of each single may be 4 µm. As the center-to-center pitch c can be in the order of the laser emission mode size, the laser areas 34 can couple with their next neighbor.

The center-to-center pitch c of immediately neighboring first sub-areas may be in a range from 0.75 to 1.75 times the diameter 2r of a single first sub-area 34. The single first sub-area diameter substantially is the mode diameter of the laser emission from the single first sub-area 34.

In Fig. 3, the laser emissions with high intensity from the first sub-areas 34 are illustrated by arrows 38. It is to be noted that there is some low-intensity emission in the second sub-areas 36.

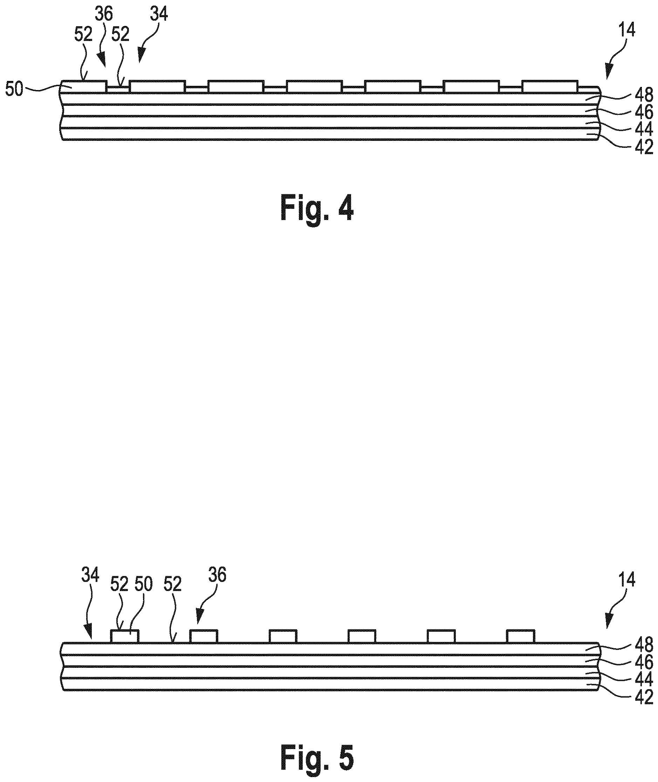

With reference to Figs. 4 and 5, several configurations of the method of fabricating the VCSEL 10 will be described how the reflectivity of the outcoupling mirror 14 can be spatially varied. Fig. 4 and Fig. 5 each show a portion of the outcoupling mirror 14 in the region of its upper layers. Four upper layers 42, 44, 46, 48 are exemplarily shown.

Fig. 4 shows an uppermost layer 50 of the outcoupling mirror 14, an upper surface 52 of which forms a semiconductor-to-air interface. The outcoupling mirror 14 may be fabricated such that the semiconductor-to-air interface 52 is in-phase with the remaining layers of the outcoupling mirror 14. By etching a part of the top layer 50, the interface 52 can be spatially made out-of-phase with the remaining layers of the outcoupling mirror 14 to decrease the reflectivity in the etched areas. The etched areas then form the second sub-areas 36, and the non-etched areas form the first sub-areas 34.

Fig. 5 shows an example useful for the understanding of the invention, in which the outcoupling mirror 14 is realized with a semiconductor-to-air interface 52 which is out-of-phase with the remaining layers of the outcoupling mirror 14. By etching a part of the top layer 50, the interface 52 can be made in-phase with the remaining layers of the outcoupling mirror 14 to increase the reflectivity in the etched area. In this example useful for the understanding of the invention, the etched areas form the first sub-areas 34 and the non-etched areas form the second sub-area(s) 36. It is advantageous to add an etch stop layer 48 to increase accuracy of the etched depth.

In another example useful for the understanding of the invention, the outcoupling mirror 14 may be realized with a semiconductor-to-air interface being in-phase with the remaining layers of the outcoupling mirror 14. By spatial deposition of an additional layer, e.g an antireflex-layer, or full area deposition and partial removal of the additional layer by e.g. etching, the reflectivity can be reduced in the areas where the deposited layer is present, forming the second sub-areas 36.

In still another example useful for the understanding of the invention, the outcoupling mirror 14 may be realized with a semiconductor-to-air interface being out-of-phase with the remaining layers of the outcoupling mirror 14. By spatial deposition of an addtional layer, e.g. an antireflex-layer, or full area deposition and partial removal of the layer by e.g. etching, the reflectivity can be increased in the area where the deposited layer is present, forming the first sub-areas.

In still another example useful for the understanding of the invention, additional reflectivity can be realized by adding dielectric mirrors on some areas of the outcoupling mirror 14, or over the full area and etching these added mirrors away in the other areas to form the second sub-areas 36.

The spatial variation of reflectivity of the outcoupling mirror 14 can be realized such that the electric field of laser emissions of immediately neighboring first sub-areas 34 oscillate in-phase or out-of-phase with respect to each other. The out-of-phase mode may be preferred over the in-phase mode, as the in-phase mode has some non-zero electrical field in the center between or outside two first sub-areas 34 (lasing regions), while the out-of-phase has zero electrical fields there and thus lower losses and thus a lower threshold.

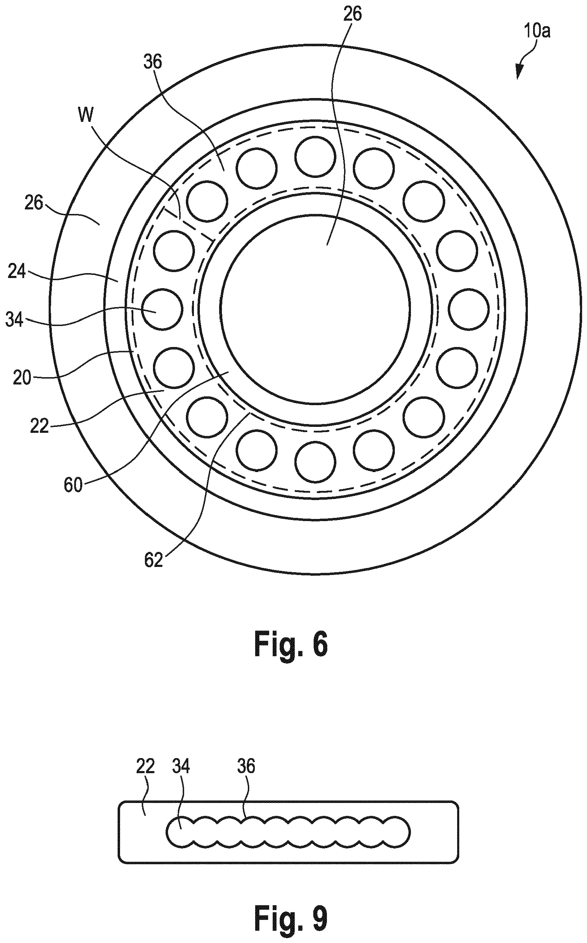

Fig. 6 shows an embodiment of a VCSEL 10a, which may have the same layer stack 12 of semiconductor layers as the VCSEL 10, except that the contiguous area 22 has an annular or ring-shape. The ring-shaped contiguous area 22 is surrounded by a current confinement region 20 indicated by a broken line in Fig. 6. A second current confinement region 62 is provided on the radially inner side of the contiguous area 22, as well as a second trench 60. An electrical contact arrangement (not shown in Fig. 6), is provided to electrically pump the active region of the semiconductor layer stack. The electrical contact arrangement may comprise an annular metal contact (not shown) on top of the VCSEL 10a.

A ring-shaped electrically pumped area (contiguous area 22) is advantageous over large e.g. round or square-shaped electrically pumped areas, for example for a diameter or side-length of 15 µm and more. The reason is that in a large round or square-shaped electrically pumped area it is difficult to achieve homogeneous current and carrier distribution, in particular as the carrier mobility in the p-mirror is relatively low. Thus, it is preferable to use a ring shape with a width w (Fig. 6) of the ring of less than 15 µm, preferably less than 10 µm.

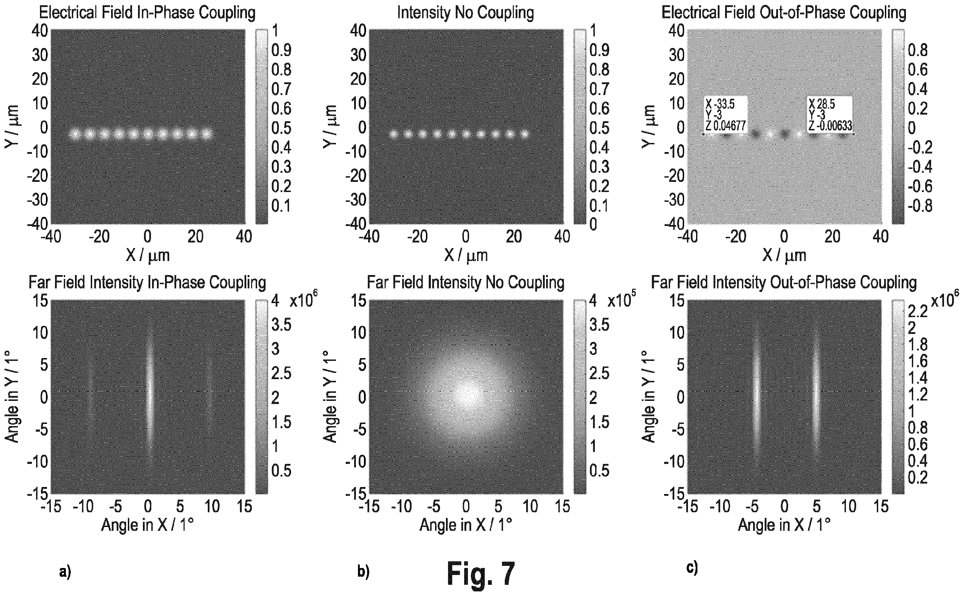

Figs. 7a)-c) show diagrams of a simulation of two possible next-neighbor coupling modes of the single lasers formed by the first sub-areas 34 of the VCSEL 10 in Fig. 1, i.e. in-phase coupling and out-of-phase coupling, as well as the beam profile if the single lasers would not be coherently coupled. The upper diagram of Fig. 7a) shows the near-field electrical field of the ten lasers or lasing positons 34 for in-phase-coupling, and the lower diagram in Fig. 7a) shows the far-field intensity profile for the in-phase coupling mode. The upper diagram of Fig. 7c) shows the near-field electrical fields of the ten laser positions, wherein the electrical field of next-neighbor laser positions has the same amplitude, but is out-of phase by 180°. The lower diagram of Fig. 7b) shows the far-field intensity for the next-neighbor out-of phase coupling. The upper diagram of Fig. 7b) shows the beam profile in the near-field if there is no coupling between neighboring lasing positions, and the lower diagram of Fig. 7b) shows the far-field intensity, if there is no coupling between neighboring laser positons.

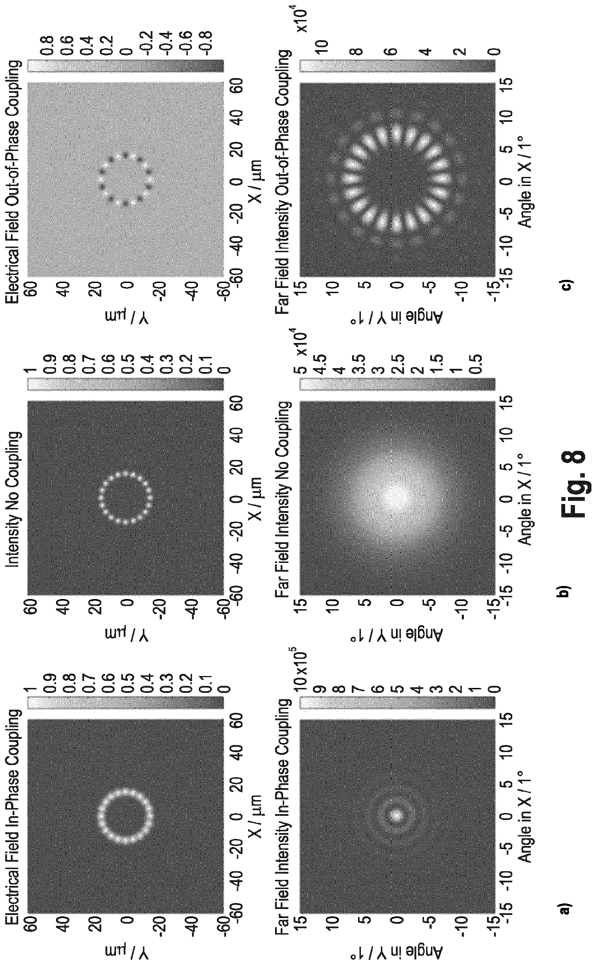

Fig. 8a)-c) show diagrams for simulations for a ring-shaped VCSEL like VCSEL 10a in Fig. 6, comprising twenty laser positions 34. The upper diagram of Fig. 8a) shows the near-field electrical field of the twenty lasers or lasing positons 34 for in-phase-coupling, and the lower diagram in Fig. 8a) shows the far-field intensity profile for the in-phase coupling mode. The upper diagram of Fig. 8c) shows the near-field electrical fields of the ten laser positions, wherein the electrical field of next-neighbor laser positions has the same amplitude, but is out-of phase by 180°. The lower diagram of Fig. 8b) shows the far-field intensity for the next-neighbor out-of phase coupling. The upper diagram of Fig. 8b) shows the beam profile in the near-field if there is no coupling between neighboring lasing positions, and the lower diagram of Fig. 8b) shows the far-field intensity, if there is no coupling between neighboring laser positons.

As can be seen in Fig. 7 and Fig. 8, in-phase coupling between neighboring laser positions 34 results in better-quality far-field beam profiles. While the out-of-phase coupling is preferred in terms of lower losses and lower thresholds, the VCSEL 10 or the VCSEL 10a may be provided with an additional layer to alter the phase of every second laser (first sub-area 34) to transform the out-of-phase mode to the in-phase mode and vice versa, or in other words to alter the phase of every second laser by 180° so that all first sub-areas are in phase.

Further, in a modification of the example useful for the understanding of the invention in Figs. 1 to 3, the contiguous area 22 can be made significantly longer in the long dimension than the linear arrays of the first sub-areas 34 (lasers). That is, end portions 70 and 72 of the electrically contiguous area 22 can be made longer than shown in Fig. 1. Although this will lead to some lost current at both edges 70, 72, it can make the linear arrays more symmetric in terms of current density and temperature to have a better homogeneity of the resonance wavelength to improve coherent coupling.

In a further modification of the example useful for the understanding of the invention in Fig. 1 and as shown in Fig. 9, the first sub-areas 34 may have a partial overlap, i.e. a center-to-center pitch of 1 or below 1, e.g. from 0.75 to 1, to form a single contiguous first sub-array (34), from which the multiple intensity peaks of the desired single non-fundamental mode emerge. It is also possible that only some neighboring of the first sub-areas 34 have a partial overlap, while other neighboring first sub-areas 34 are separated from each other, depending on the desired mode to be emitted. In Fig. 9, only a section of the VCSEL in the region of the contiguous area 22 with the first and second sub-areas 34, 36 is shown for the sake of simplicity.

As exemplarily illustrated for only a part of the surface of the outcoupling mirror 14 in Fig. 1, an additional grating structure 74 may be provided on top of the outcoupling mirror 14, at least in the region of the first sub-areas 34, in the embodiment in Fig. 6 to stabilize a single polarization direction.

Further, a thin proton implantation may be provided between the first sub-areas 34 and the second sub-areas 36 to decrease electrical losses between lasers. Alternatively or in addition, the proton implantation may be applied at the edges of the contiguous area where the intensity of the single mode is low, such that the current is directed towards the region with high intensity for a more efficient pumping of the active layer at the positions of the intensity peaks of the single high-order mode.

While the invention has been illustrated and described in detail in the drawings and foregoing description, such illustration and description are to be considered illustrative or exemplary and not limiting; the invention is not limited to the disclosed embodiments. Other variations to the disclosed embodiments can be understood and effected by those skilled in the art and practicing the claimed invention, from a study of the drawings, the disclosure and the appended claims as long as they fall under the invention as claimed.

In the claims, the verb "comprising" does not exclude other elements or steps, and the indefinite article "a" or "an" does not exclude a plurality. A single element or other unit may fulfill the functions of several items recited in the claims. The mere fact that certain measures are recited in mutual different claims does not indicate that a combination of these measures cannot be used to advantage.

Any reference signs in the claims not should not be construed as limiting the scope.

## Claims

1. Vertical Cavity Surface Emitting Laser, comprising a semiconductor layer structure (12) including a first mirror (13), an outcoupling mirror (14) and an active region (16) between the first mirror (13) and the outcoupling mirror (14), further comprising an electrical contact arrangement (30), and a current confinement region (20) which surrounds a contiguous area (22) of the layer structure (12), wherein the electrical contact arrangement (30) is arranged to electrically pump the active region (16) to generate laser emission in a single non-fundamental mode extending over the contiguous area (22), wherein the outcoupling mirror (14) has a first reflectivity in one or more first sub-areas (34) of the contiguous area (22) and a second reflectivity in one or more second sub-areas (36) of the contiguous area (22) outside the one or more first sub-areas (34), wherein the second reflectivity is lower than the first reflectivity and the single non-fundamental mode has two or more intensity peaks in the one or more first sub-areas (34) and an intensity in the one or more second sub-areas (36) which is lower than 50% of the intensity in the first sub-areas (34) wherein the contiguous area (22) is electrically separated from remaining portions (26) of the layer stack (12) by a first trench (24), **characterized in that** the contiguous area (22) has a ring shape, wherein a further current confinement region (62) and a second trench (60) are arranged on the radially inner side of the ring-shaped contiguous area (22).

2. Vertical Cavity Surface Emitting Laser of claim 1, wherein a center-to-center pitch (c) of immediately neighboring first sub-areas (34) is in a range from 0.75 to 1.75 times a single first sub-area diameter.

3. Vertical Cavity Surface Emitting Laser of anyone of claims 1 to 2, wherein the first reflectivity and the second reflectivity are such that an intensity of the single non-fundamental mode in the one or more first sub-areas (34) is larger than an intensity of the single non-fundamental mode in the one or more second sub-areas (36) by a factor of at least 3, preferably at least 4, further preferably at least 5.

4. Vertical Cavity Surface Emitting Laser of anyone of claims 1 to 3, wherein the first and second sub-areas (34, 36) are arranged such that the intensity peaks of the single non-fundamental mode in the one or more first sub-areas (34) are out-of-phase among two immediately neighboring intensity peaks.

5. Vertical Cavity Surface Emitting Laser of claim 4, wherein the outcoupling mirror (14) comprises an additional layer which alters the phase of each second intensity peak from out-of-phase to in-phase or vice versa.

6. Vertical Cavity Surface Emitting Laser of anyone of claims 1 to 5, wherein the first and second sub-areas (34, 36) are arranged such that the intensity peaks of the single non-fundamental mode in the one or more first sub-areas (34) are in-phase among two immediately neighboring intensity peaks.

7. Vertical Cavity Surface Emitting Laser of anyone of claims 1 to 6, wherein a grating structure (74) is arranged on the one or more first sub-areas (34) configured to stabilize a single polarization direction of the laser emission.

8. Vertical Cavity Surface Emitting Laser of anyone of claims 1 to 7, wherein in the region of the one or more second sub-areas (36) the layer stack (12) comprises an ion implant.

9. A method of fabricating a Vertical Cavity Surface Emitting Laser (10; 10a), comprising:
providing a layer stack (12) of semiconductor layers of a first mirror (13), an outcoupling mirror (14) and an active region (16) between the first mirror (13) and the outcoupling mirror (14),
providing a current confinement region (20) surrounding a contiguous area (22) of the layer stack (12), wherein the contiguous area (22) has a ring shape, and providing a further current confinement region (62) on the radially inner side of the ring-shaped contiguous area (22), wherein the contiguous area (22) is electrically separated from remaining portions (26) of the layer stack (12) by a first trench (24), wherein a second trench (60) is provided on the radially inner side of the ring-shaped contiguous area (22),
providing an electrical contact arrangement (30) for electrically pumping the active region (16) to generate laser emission in a single non-fundamental mode extending over the contiguous area (22),
wherein the outcoupling mirror (14) is provided with a first reflectivity in one or more first sub-areas (34) of the contiguous area (22) and a second reflectivity in one or more second sub-areas (36) outside the one or more first sub-areas (34), wherein the second reflectivity is lower than the first reflectivity such that the single non-fundamental mode has two or more intensity peaks in the one or more first sub-areas (34) and an intensity in the one or more second sub-areas (36) which is lower than 50% of the intensity in the first sub-areas (34).

## Patentansprüche

1. Oberflächenemittierender Laser mit vertikalem Hohlraum, umfassend eine Halbleiterschichtstruktur (12) mit einem ersten Spiegel (13), einem auskoppelnden Spiegel (14) und einem aktiven Bereich (16) zwischen dem ersten Spiegel (13) und dem auskoppelnden Spiegel (14), ferner umfassend eine elektrische Kontaktanordnung (30) und einen Strombegrenzungsbereich (20), der einen zusammenhängenden Bereich (22) der Schichtstruktur (12) umgibt, wobei die elektrische Kontaktanordnung (30) angeordnet ist, den aktiven Bereich (16) elektrisch zu pumpen, um Laseremission in einem einzelnen nicht fundamentalen Modus zu erzeugen, der sich über den zusammenhängenden Bereich (22) erstreckt, wobei der auskoppelnde Spiegel (14) eine erste Reflektivität in einem oder mehreren ersten Teilbereichen (34) des zusammenhängenden Bereichs (22) und eine zweite Reflektivität in einem oder mehreren zweiten Teilbereichen (36) des zusammenhängenden Bereichs (22) außerhalb des einen oder der mehreren ersten Teilbereiche (34) aufweist, wobei die zweite Reflektivität geringer ist als die erste Reflektivität und der einzelne nicht-fundamentale Modus zwei oder mehr Intensitätsspitzen in dem einen oder den mehreren ersten Teilbereichen (34) und eine Intensität in dem einen oder den mehreren zweiten Teilbereichen (36) aufweist, die geringer ist als 50 % der Intensität in den ersten Teilbereichen (34), wobei der zusammenhängende Bereich (22) durch einen ersten Graben (24) von restlichen Abschnitten (26) des Schichtstapels (12) elektrisch getrennt ist, **dadurch gekennzeichnet, dass** der zusammenhängende Bereich (22) eine Ringform aufweist, wobei ein weiterer Strombegrenzungsbereich (62) und ein zweiter Graben (60) an der radial inneren Seite des ringförmigen zusammenhängenden Bereichs (22) angeordnet sind.

2. Oberflächenemittierender Laser mit vertikalem Hohlraum nach Anspruch 1, wobei der Abstand (c) von Mitte zu Mitte unmittelbar benachbarter erster Teilbereiche (34) in einem Bereich vom 0,75- bis 1,75-fachen des Durchmessers eines einzelnen ersten Teilbereichs liegt.

3. Oberflächenemittierender Laser mit vertikalem Hohlraum nach einem der Ansprüche 1 bis 2, wobei die erste Reflektivität und die zweite Reflektivität so beschaffen sind, dass eine Intensität des einzelnen nicht-fundamentalen Modus in dem einen oder den mehreren ersten Teilbereichen (34) größer ist als eine Intensität des einzelnen nicht-fundamentalen Modus in dem einen oder den mehreren zweiten Teilbereichen (36) um einen Faktor von mindestens 3, vorzugsweise mindestens 4, weiter bevorzugt mindestens 5.

4. Oberflächenemittierender Laser mit vertikalem Hohlraum nach einem der Ansprüche 1 bis 3, wobei der erste und der zweite Teilbereich (34, 36) so angeordnet sind, dass die Intensitätsspitzen des einzelnen nicht fundamentalen Modus in dem einen oder den mehreren ersten Teilbereichen (34) zwischen zwei unmittelbar benachbarten Intensitätsspitzen phasenverschoben sind.

5. Oberflächenemittierender Laser mit vertikalem Hohlraum nach Anspruch 4, wobei der auskoppelnde Spiegel (14) eine zusätzliche Schicht umfasst, welche die Phase jeder zweiten Intensitätsspitze von phasenverschoben zu gleichphasig oder umgekehrt ändert.

6. Oberflächenemittierender Laser mit vertikalem Hohlraum nach einem der Ansprüche 1 bis 5, wobei der erste und der zweite Teilbereich (34, 36) so angeordnet sind, dass die Intensitätsspitzen des einzelnen nicht fundamentalen Modus in dem einen oder den mehreren ersten Teilbereichen (34) zwischen zwei unmittelbar benachbarten Intensitätsspitzen gleichphasig sind.

7. Oberflächenemittierender Laser mit vertikalem Hohlraum nach einem der Ansprüche 1 bis 6, wobei eine Gitterstruktur (74) auf dem einen oder den mehreren ersten Teilbereichen (34) angeordnet ist, die zur Stabilisierung einer einzelnen Polarisationsrichtung der Laseremission konfiguriert ist.

8. Oberflächenemittierender Laser mit vertikalem Hohlraum nach einem der Ansprüche 1 bis 7, wobei der Schichtstapel (12) im Bereich des einen oder der mehreren zweiten Teilbereiche (36) ein lonenimplantat umfasst.

9. Verfahren zur Herstellung eines oberflächenemittierenden Lasers mit vertikalem Hohlraum (10; 10a), umfassend:
Bereitstellen eines Schichtstapels (12) von Halbleiterschichten aus einem ersten Spiegel (13), einem auskoppelnden Spiegel (14) und einem aktiven Bereich (16) zwischen dem ersten Spiegel (13) und dem auskoppelnden Spiegel (14),
Bereitstellen eines Strombegrenzungsbereichs (20), der einen zusammenhängenden Bereich (22) des Schichtstapels (12) umgibt, wobei der zusammenhängende Bereich (22) eine Ringform aufweist, und Bereitstellen eines weiteren Strombegrenzungsbereichs (62) auf der radial inneren Seite des ringförmigen zusammenhängenden Bereichs (22), wobei der zusammenhängende Bereich (22) von restlichen Abschnitten (26) des Schichtstapels (12) durch einen ersten Graben (24) elektrisch getrennt ist, wobei ein zweiter Graben (60) auf der radial inneren Seite des ringförmigen zusammenhängenden Bereichs (22) bereitgestellt ist,
Bereitstellen einer elektrischen Kontaktanordnung (30) zum elektrischen Pumpen des aktiven Bereichs (16), um eine Laseremission in einem einzelnen nicht-fundamentalen Modus zu erzeugen, der sich über den zusammenhängenden Bereich (22) erstreckt,
wobei der auskoppelnde Spiegel (14) mit einer ersten Reflektivität in einem oder mehreren ersten Teilbereichen (34) des zusammenhängenden Bereichs (22) und einer zweiten Reflektivität in einem oder mehreren zweiten Teilbereichen (36) außerhalb des einen oder der mehreren ersten Teilbereiche (34) bereitgestellt wird, wobei die zweite Reflektivität niedriger als die erste Reflektivität ist, sodass der einzelne nicht-fundamentale Modus zwei oder mehr Intensitätsspitzen in dem einen oder den mehreren ersten Teilbereichen (34) und eine Intensität in dem einen oder den mehreren zweiten Teilbereichen (36) aufweist, die niedriger als 50 % der Intensität in den ersten Teilbereichen (34) ist.

## Revendications

1. Laser à émission de surface à cavité verticale, comprenant une structure de couches (12) semi-conductrices incluant un premier miroir (13), un miroir de découplage (14) et une région active (16) entre le premier miroir (13) et le miroir de découplage (14), comprenant en outre un dispositif de contact électrique (30), et une région de confinement (20) du courant entourant une zone contiguë (22) de la structure de couches (12), dans lequel le dispositif de contact électrique (30) est conçu pour pomper électriquement la région active (16) pour générer une émission laser dans un mode non fondamental unique s'étendant sur la zone contiguë (22), dans lequel le miroir de découplage (14) présente une première réflectivité dans une ou plusieurs premières sous-zones (34) de la zone contiguë (22) et une seconde réflectivité dans une ou plusieurs secondes sous-zones (36) de la zone contiguë (22) à l'extérieur de la ou des premières sous-zones (34), dans lequel la seconde réflectivité est inférieure à la première réflectivité et le mode non fondamental unique présente deux pics d'intensité ou plus dans une ou plusieurs premières sous-zones (34) et une intensité dans une ou plusieurs secondes sous-zones (36) inférieure à 50 % de l'intensité dans les premières sous-zones (34), dans lequel la zone contiguë (22) est électriquement séparée des parties restantes (26) de l'empilement de couches (12) par une première tranchée (24), **caractérisé en ce que** la zone contiguë (22) a une forme d'anneau, dans lequel une autre région de confinement (62) du courant et une seconde tranchée (60) sont disposées sur le côté radialement intérieur de la zone contiguë (22) en forme d'anneau.

2. Laser à émission de surface à cavité verticale selon la revendication 1, dans lequel le pas centre à centre (c) des premières sous-zones (34) immédiatement voisines est compris entre 0,75 et 1,75 fois le diamètre d'une seule première sous-zone.

3. Laser à émission de surface à cavité verticale selon l'une quelconque des revendications 1 à 2, dans lequel la première réflectivité et la seconde réflectivité sont telles qu'une intensité du mode non fondamental unique dans la ou les premières sous-zones (34) est supérieure à une intensité du mode non fondamental unique dans la ou les secondes sous-zones (36) d'un facteur d'au moins 3, préférablement d'au moins 4, et encore plus préférablement d'au moins 5.

4. Laser à émission de surface à cavité verticale selon l'une quelconque des revendications 1 à 3, dans lequel les premières et secondes sous-zones (34, 36) sont disposées de telle sorte que les pics d'intensité du mode non fondamental unique dans la ou les premières sous-zones (34) sont déphasés par rapport à deux pics d'intensité immédiatement voisins.

5. Laser à émission de surface à cavité verticale selon la revendication 4, dans lequel le miroir de découplage (14) comprend une couche supplémentaire modifiant la phase de chaque second pic d'intensité de déphasé à en phase ou vice versa.

6. Laser à émission de surface à cavité verticale selon l'une quelconque des revendications 1 à 5, dans lequel les premières et secondes sous-zones (34, 36) sont disposées de telle sorte que les pics d'intensité du mode non fondamental unique dans la ou les premières sous-zones (34) sont en phase par rapport à deux pics d'intensité immédiatement voisins.

7. Laser à émission de surface à cavité verticale selon l'une quelconque des revendications 1 à 6, dans lequel une structure grillagée (74) est disposée sur la ou les premières sous-zones (34) et est configurée pour stabiliser une direction de polarisation unique de l'émission laser.

8. Laser à émission de surface à cavité verticale selon l'une quelconque des revendications 1 à 7, dans lequel, dans la région de la ou des secondes sous-zones (36), l'empilement de couches (12) comprend un implant ionique.

9. Méthode de fabrication d'un laser à émission de surface à cavité verticale (10 ; 10a), comprenant :
fournir un empilement de couches (12) semi-conductrices d'un premier miroir (13), d'un miroir de découplage (14) et d'une région active (16) entre le premier miroir (13) et le miroir de découplage (14),
fournir une région de confinement (20) du courant entourant une zone contiguë (22) de l'empilement de couches (12), dans laquelle la zone contiguë (22) a une forme d'anneau, et fournir une autre région de confinement (62) du courant sur le côté radialement intérieur de la zone contiguë (22) en forme d'anneau, dans laquelle la zone contiguë (22) est électriquement séparée des parties restantes (26) de l'empilement de couches (12) par une première tranchée (24), dans laquelle une seconde tranchée (60) est prévue sur le côté radialement intérieur de la zone contiguë (22) en forme d'anneau,
fournir un dispositif de contact électrique (30) destiné à pomper électriquement la région active (16) pour générer une émission laser dans un mode non fondamental unique s'étendant sur la zone contiguë (22),
dans laquelle le miroir de découplage (14) présente une première réflectivité dans une ou plusieurs premières sous-zones (34) de la zone contiguë (22) et une seconde réflectivité dans une ou plusieurs secondes sous-zones (36) à l'extérieur de la ou des premières sous-zones (34), dans laquelle la seconde réflectivité est inférieure à la première réflectivité de sorte que le mode non fondamental unique présente deux pics d'intensité ou plus dans la ou les premières sous-zones (34) et une intensité dans la ou les secondes sous-zones (36) inférieure à 50 % de l'intensité dans les premières sous-zones (34).
